# EUROPÄISCHE PATENTSCHRIFT

(11) **EP 1 735 851 B1**
(45) Veröffentlichungstag und Bekanntmachung des Hinweises auf die Patenterteilung: **24.12.2008**
(21) Anmeldenummer: 05728180.0
(22) Anmeldetag: 04.04.2005
(51) Int. Cl.: H01L 51/00, H01L 51/50

(54) **VERWENDUNG VON METALLOCENKOMPLEXEN VON METALLEN DER 4. NEBENGRUPPE DES PERIODENSYSTEMS ALS TRIPLETTEMITTER IN ORGANISCHEN LEUCHTDIODEN (OLEDS)**
USE OF METALLOCENE COMPLEXES OF METALS IN THE 4TH SUB-GROUP OF THE PERIODIC TABLE AS TRIPLE EMITTERS IN ORGANIC LIGHT-EMITTING DIODES (OLEDS)
UTILISATION DE COMPLEXES DE METALLOCENE DU SOUS-GROUPE 4 DU SYSTEME PERIODIQUE EN TANT QU'EMETTEUR TRIPLE DANS DES DIODES ELECTROLUMINESCENTES ORGANIQUES

(30) Priorität: 08.04.2004 DE 102004018145
(43) Veröffentlichungstag der Anmeldung: 27.12.2006
(73) Patentinhaber: BASF SE, 67056 Ludwigshafen (DE)
(72) Erfinder: GESSNER, Thomas, 69120 Heidelberg (DE); KÖNEMANN, Martin, 68163 Mannheim (DE); SCHMIDT, Hans-Werner, 95444 Bayreuth (DE); THELAKKAT, Mukundan, 95445 Bayreuth (DE); BAETE, Markus, 95508 Kulmain (DE)
(74) Vertreter: Isenbruck, Günter
(86) Internationale Anmeldenummer: PCT/EP2005/003516
(87) Internationale Veröffentlichungsnummer: WO 2005/098988

(56) Entgegenhaltungen:
- WO-A-02/101847
- E. HONG ET AL: "Mechano- and Electroluminescence of a Dissymmetric Hafnium Carborane Complex" ADVANCED MATERIALS, Bd. 13, Nr. 14, 18. Juli 2001 (2001-07-18), Seiten 1094-1096, XP002329718
- BALDO M A ET AL: "PHOSPHORESCENT MATERIALS FOR APPLICATION TO ORGANIC LIGHT EMITTING DEVICES" PURE & APPLIED CHEMISTRY, PERGAMON PRESS, OXFORD, GB, Bd. 71, Nr. 11, 1999, Seiten 2095-2106, XP001182482 ISSN: 0033-4545
- V. W.-W. YAM, ET AL: "Synthesis of luminescent zirconium thiolate complexes. Crystal structures of (?5-C5H5)2Zr(SC6H4Cl-p)2 and [(?5-C5H5)2Zr(SC6H4OMe-p)]2O" JOURNAL OF ORGANOMETALLIC CHEMISTRY, Bd. 548, 1997, Seiten 289-294, XP002329719 in der Anmeldung erwähnt
- G. V. LOUKOVA AND V. A. SMIRNOV: "Phosphorescent ligand-to-metal charge-transfer excited states in the group IVB metallocene triad" CHEMICAL PHYSICS LETTERS, Bd. 329, 27. Oktober 2000 (2000-10-27), Seiten 437-442, XP002329720 in der Anmeldung erwähnt
- J. W. KENNEY ET AL: "Electronic Luminescence Spectra of Charge Transfer States of Titanium(IV) Metallocenes" ORGANOMETALLICS, Bd. 12, 1993, Seiten 3671-3676, XP002329721

## Beschreibung

Die vorliegende Erfindung betrifft die Verwendung von Metallocenkomplexen von Metallen der 4. Nebengruppe des Periodensystems als Emittermoleküle in organischen Leuchtdioden (OLEDs), die Verwendung der Metallocenkomplexe als Licht-emittierende Schicht in OLEDs, eine Licht-emittierende Schicht enthaltend mindestens einen Metallocenkomplex, ein OLED enthaltend diese Licht-emittierende Schicht sowie Vorrichtungen, die ein erfindungsgemäßes OLED enthalten.

In organischen Leuchtdioden (OLED) wird die Eigenschaft von Materialien ausgenutzt, Licht zu emittieren, wenn sie durch elektrischen Strom angeregt werden. OLEDs sind insbesondere interessant als Alternative zu Kathodenstrahlröhren und Flüssigkristalldisplays zur Herstellung von Flachbildschirmen. Aufgrund der sehr kompakten Bauweise und des intrinsisch niedrigeren Stromverbrauchs eignen sich Vorrichtungen, enthaltend OLEDs insbesondere für mobile Anwendungen, zum Beispiel für Anwendungen in Handys, Laptops usw.

Es wurden zahlreiche Materialien vorgeschlagen, die bei der Anregung durch elektrischen Strom Licht emittieren (Elektrolumineszenz).

Baldo et al., Pure Appl. Chem., 1999, 71(11), 2095 bis 2106 beschreibt in Anwendung von phosphoreszierenden Materialien in OLEDs.

In dem nachfolgend genannten Stand der Technik ist die Photolumineszenz von speziellen Zirconiumkomplexen beschrieben. Bezüglich einer Elektrolumineszenz von Zirconocen- oder Hafnocenkomplexen, die für den Einsatz in organischen Licht-emittierenden Dioden (OLEDs) erforderlich ist, ist kein Stand der Technik bekannt.

Vogler et al., Eur. J. Inorg. Chem. 1998, 1863 bis 1865 betrifft die Untersuchung des Li-gand-Ligand-Ladungstransfers in (2,2'-Bischinolinolato)bis(cyclopentadienyl)-zirconium(IV). Dieser Komplex zeigt Emission im sichtbaren Bereich des elektromagnetischen Spektrums, wenn er mit Licht angeregt wird.

Loukova et al., Chemical Physics Letters 329 (2000) 437 bis 442 betrifft phosphoreszierende angeregte Zustände in der Metallocenen Gruppe IVa des Periodensystems der Elemente. Diese Komplexe zeigen Lumineszenz, wenn sie mit Licht angeregt werden.

Yam et al., Journal of Organometallic Chemistry 548 (1997) 289 bis 294, betrifft die Synthese von Zirconiumthiolatkomplexen der Formel (η⁵-C₅H₅)₂Zr(SC₆H₄R-p)₂, worin R Cl, Me oder OMe bedeutet. Diese Komplexe zeigen bei Anregung mit Licht Lumineszenz im sichtbaren Bereich des elektromagnetischen Spektrums.

In keinem der vorstehend genannten Dokumente wird die Elektrolumineszenz von Zirconocenkomplexen erwähnt.

Obwohl bereits Verbindungen bekannt sind, die im blauen, roten und grünen Bereich des elektromagnetischen Spektrums Elektrolumineszenz zeigen, ist die Bereitstellung von weiteren Verbindungen, die auch in Substanz als Licht-emittierende Schicht einsetzbar sind, wünschenswert. Unter Elektrolumineszenz ist sowohl Elektrofluoreszenz als auch Elektrophosphoreszenz zu verstehen.

Aufgabe der vorliegenden Anmeldung ist daher die Bereitstellung einer Verbindungsklasse, die zum Einsatz in verschiedenen Schichten eines OLEDs geeignet ist, insbesondere die Bereitstellung einer Verbindung, die zur Elektrolumineszenz im blauen, roten und grünen Bereich des elektromagnetischen Spektrums geeignet ist, wodurch die Herstellung von Vollfarbendisplays ermöglicht wird.

Diese Aufgabe wird gelöst durch die Verwendung von Metallocenkomplexen gemäß Anspruch 1.

Die Metallocenkomplexe können in der Licht-emittierenden Schicht eines OLEDs als Emittersubstanz oder als Matrixmaterial eingesetzt werden. Des Weiteren ist der Einsatz der Metallocenkomplexe als Lochblocker möglich, z. B. in einer Blockschicht für Löcher, die zwischen einer Licht-emittierenden Schicht und einer Elektronen-transportierenden Schicht des OLEDs angeordnet ist. Bevorzugt werden die Metallocenkomplexe als Emittermoleküle in der Licht-emittierenden Schicht eingesetzt.

Erfindungsgemäß eingsetzt werden dabei neutrale Zirconocenkomplexe der Formel (I) 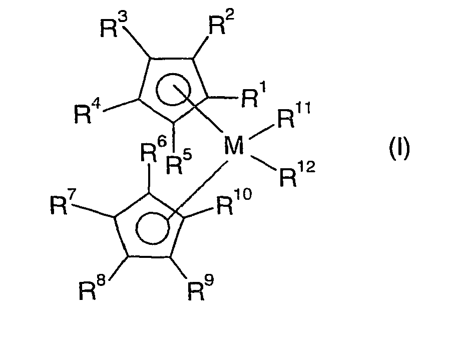 worin die Symbole die folgenden Bedeutungen aufweisen:
- R¹, R², R³, R⁴, R⁵, R⁶, R⁷, R⁸, R⁹, R¹⁰: unabhängig voneinander H, Alkyl, Aryl, Alkoxy, Hydroxy, Aryloxy, Halogen, CN, SCN, NO₂ CR¹⁷R¹⁸NR¹⁹R²⁰, CF₃; wobei R¹⁷, R¹⁸, R¹⁹, R²⁰ jeweils unabhängig voneinander H, Alkyl oder Aryl bedeuten;
oder
zwei benachbarte Reste bilden gemeinsam mit den Kohlenstoffatomen, an die sie gebunden sind, einen zyklischen Rest, der gesättigt oder ungesättigt und substituiert oder unsubstituiert sein kann und gegebenenfalls ein oder mehrere Heteroatome, bevorzugt ausgewählt aus N, O oder S, enthalten kann;
und/oder
- R⁵ und R¹⁰: bilden gemeinsam eine Verbrückung, die die allgemeine Formel - (CR¹³R¹⁴)ₙ- aufweist, wobei R¹³ und R¹⁴ jeweils unabhängig voneinander H, Alkyl oder Aryl bedeuten, n 1 bis 2 bedeutet und die Reste R¹³ und R¹⁴ in den n Gruppen -(CR¹³R¹⁴)- gleich oder verschieden sein können und in einer oder mehreren der Gruppen -(CR¹³R¹⁴)- das Kohlenstoffatom durch Si oder B ersetzt sein kann;
- R¹¹, R¹²: unabhängig voneinander Alkyl ausgewählt aus der Gruppe bestehend aus Methyl, Ethyl, i-Propyl, n-Propyl, i-Butyl, n-Butyl, t-Butyl, sec-Butyl, i-Pentyl, n-Pentyl, sec-Pentyl, neo-Pentyl, n-Hexyl, i-Hexyl, sec-Hexyl, Cyclohexyl und Cyclopentyl, Aryl, Alkoxy, Aryloxy, Halogen, CN, SCN, CO, Alkinyl, Alkylthio, Arylthio, Alkylamido, Arylamide, Trifluormethansulfonat oder einer der Reste bildet eine µ-oxo-Brücke zu einem weiteren Zirconocen- oder Hafnocenkomplex der Formel I aus;
oder
- R¹¹ und R¹²: bilden gemeinsam einen zweizähnigen Liganden;
- M: Zr

Die Zirconocenkomplexe der Formel I werden bevorzugt als Matrixmaterial oder als Emittermolekül in der Licht-emittierenden Schicht oder als Lockblocker eingesezt. Besonders bevorzugt ist die Verwendung der Zirconocenkomplexe der Formel I als Emittermoleküle in der Licht-emittierenden Schicht.

Im Sinne der vorliegenden Anmeldung haben die Begriffe Arylrest oder -gruppe, Alkylrest oder -gruppe, Alkoxyrest oder -gruppe und Aryloxyrest oder -gruppe die folgenden Bedeutungen:

Unter einem Arylrest (oder -gruppe) ist ein Rest mit einem Grundgerüst von 6 bis 30 Kohlenstoffatomen, bevorzugt 6 bis 18 Kohlenstoffatomen zu verstehen, der aus einem aromatischen Ring oder mehreren kondensierten aromatischen Ringen aufgebaut ist. Geeignete Grundgerüste sind zum Beispiel Phenyl, Naphthyl, Anthracenyl oder Phenanthrenyl. Dieses Grundgerüst kann unsubstituiert sein (d. h., dass alle Kohlenstoffatome, die substituierbar sind, Wasserstoffatome tragen), oder an einer, mehreren oder allen substituierbaren Positionen des Grundgerüsts substituiert sein. Geeignete Substituenten sind zum Beispiel Alkylreste, bevorzugt Alkylreste mit 1 bis 8 Kohlenstoffatomen, besonders bevorzugt Methyl, Ethyl, i-Propyl oder t-Butyl, Arylreste, bevorzugt C₆-Arylreste, die wiederum substituiert oder unsubstituiert sein können, Heteroarylreste, bevorzugt Heteroarylreste, die mindestens ein Stickstoffatom enthalten, besonders bevorzugt Pyridylreste, Alkenylreste, bevorzugt Alkenylreste, die eine Doppelbindung tragen, besonders bevorzugt Alkenylreste mit einer Doppelbindung und 1 bis 8 Kohlenstoffatomen, oder Gruppen mit Donor- oder Akzeptorwirkung. Unter Gruppen mit Donorwirkung sind Gruppen zu verstehen, die einen +I- und/oder +M-Effekt aufweisen, und unter Gruppen mit Akzeptorwirkung sind Gruppen zu verstehen, die einen -I- und/oder -M-Effekt aufweisen. Geeignete Gruppen, mit Donor- oder Akzeptorwirkung sind Halogenreste, bevorzugt F, Cl, Br, besonders bevorzugt F, Alkoxyreste, Carbonylreste, Esterreste, Aminreste, Amidreste, CH₂F-Gruppen, CHF₂-Gruppen, CF₃-Gruppen, CN-Gruppen, Thiogruppen oder SCN-Gruppen. Ganz besonders bevorzugt tragen die Arylreste Substituenten ausgewählt aus der Gruppe bestehend aus Methyl, F, Cl und Alkoxy, oder die Arylreste sind unsubstituiert. Bevorzugt ist der Arylrest oder die Arylgruppe ein C₆-Arylrest, der gegebenenfalls mit mindestens einem der vorstehend genannten Substituenten substituiert ist. Besonders bevorzugt weist der C₆-Arylrest keinen, einen oder zwei der vorstehend genannten Substituenten auf, wobei der eine Substituent bevorzugt in para-Position zur weiteren Verknüpfungsstelle des Arylrestes angeordnet ist und - im Falle von zwei Substituenten - diese jeweils in meta-Position zur weiteren Verknüpfungsstelle des Arylrestes angeordnet sind. Ganz besonders bevorzugt ist der C₆-Arylrest ein unsubstituierter Phenylrest.

Unter einem Alkylrest oder einer Alkylgruppe ist ein Rest mit 1 bis 20 Kohlenstoffatomen, bevorzugt 1 bis 10 Kohlenstoffatomen, besonders bevorzugt 1 bis 8 Kohlenstoffatomen zu verstehen. Dieser Alkylrest kann verzweigt oder unverzweigt sein und gegebenenfalls mit einem oder mehreren Heteroatomen, bevorzugt N, O oder S unterbrochen sein. Des Weiteren kann dieser Alkylrest mit einem oder mehreren der bezüglich der Arylgruppen genannten Substituenten substituiert sein. Es ist ebenfalls möglich, dass der Alkylrest eine oder mehrere Arylgruppen trägt. Dabei sind alle der vorstehend aufgeführten Arylgruppen geeignet. Des Weiteren kann der Alkylrest oder die Alkylgruppe ein cyclischer Alkylrest mit 3 bis 10 Ringatomen, bevorzugt 4 bis 7 Ringatomen sein. Bei den Ringatomen handelt es sich um Kohlenstoffatome, wobei ein oder mehrere Kohlenstoffatome durch Heteroatome, bevorzugt N, O oder S, ersetzt sein können. Der cyclische Alkylrest kann mit den bereits bezüglich der verzweigten oder unverzweigten Alkylreste genannten Substituenten substituiert sein. Besonders bevorzugt sind die Alkylreste ausgewählt aus der Gruppe bestehend aus Methyl, Ethyl, i-Propyl, n-Propyl, i-Butyl, n-Butyl, t-Butyl, sec-Butyl, i-Pentyl, n-Pentyl, sec-Pentyl, neo-Pentyl, n-Hexyl, i-Hexyl und sec-Hexyl, Cyclohexyl und Cyclopentyl. Ganz besonders bevorzugt sind Methyl, i-Propyl, t-Butyl und n-Hexyl.

Unter einem Alkoxyrest oder einer Alkoxygruppe ist eine Gruppe der allgemeinen Formel -OR¹⁵ zu verstehen, wobei R¹⁵ einen Alkylrest darstellt, wie er vorstehend definiert ist. Bevorzugte Alkoxyreste sind somit Alkoxyreste ausgewählt aus der Gruppe bestehend aus -OMethyl, -OEthyl, -OⁱPropyl, -OⁿPropyl, -OⁱButyl, -OⁿButyl, -O^{t}Butyl, - O^{sec}Butyl, - OⁱPentyl, -OⁿPentyl, -O^{sec}Pentyl, -O^{neo}Pentyl, -OⁿHexyl, -OⁱHexyl und - O^{sec}Hexyl. Ganz besonders bevorzugt sind -OMethyl, -OⁱPropyl, -O^{t}Butyl und -OⁿHexyl.

Unter einem Aryloxyrest bzw. einer Aryloxygruppe ist eine Gruppe der allgemeinen Formel -OR¹⁶ zu verstehen, wobei R¹⁶ einen Arylrest darstellt, wie er vorstehend definiert ist. Als Aryloxyrest ist ein Rest der Gruppe -OPhenyl ganz besonders bevorzugt.

Unter einem Alkylthiorest oder einer Alkylthiogruppe ist eine Gruppe der allgemeinen formel -SR²¹ zu verstehen, wobei R²¹ einen Alkylrest darstellt, wie er vorstehend definiert ist. Bevorzugte Alkylthioreste sind somit Alkylthioreste ausgewählt aus der Gruppe bestehend aus -SMethyl, -SEthyl, -SⁱPropyl, -SⁿPropyl, -SⁱButyl, SⁿButyl, -S^{t}Butyl, -S^{sec}Butyl, -SⁱPentyl, -SⁿPentyl, -S^{sec}Pentyl, -S^{neo}Pentyl, -SⁿHexyl, -SⁱHexyl und -S^{sec}Hexyl. Ganz besonders bevorzugt sind -SMethyl, -SⁱPropyl, -S^{t}Butyl und -SⁿHexyl.

Unter einem Arylthiorest bzw. einer Arylthiogruppe ist eine Gruppe der allgemeinen Formel -SR²² zu verstehen, wobei R²² einen Arylrest darstellt, wie er vorstehend definiert ist. Als Arylthiorest ist ein Rest der Gruppe -SPhenyl ganz besonders bevorzugt.

Bei dem Substituenten Halogen handelt es sich bevorzugt um F, Cl oder Br, besonders bevorzugt um Cl oder Br, ganz besonders bevorzugt um Cl.

Unter einem zweizähnigen Liganden ist ein Ligand zu verstehen, der zwei Koordinationsstellen aufweist. Geeignete zweizähnige Liganden sind zum Beispiel Bis(chinolinolato), 2,2'-Bipyridin, 2,2'-Bipyridindisulfonate und Phenanthrolin.

In einer bevorzugten Ausführungsform der vorliegenden Erfindung bedeuten R¹, R², R³, R⁴, R⁵, R⁶, R⁷, R⁸, R⁹ und R¹⁰ unabhängig voneinander H oder Alkyl, besonders bevorzugt Alkyl ausgewählt aus der Gruppe bestehend aus Methyl, Ethyl, i-Propyl, n-Propyl, i-Butyl, n-Butyl, t-Butyl, sec-Butyl, i-Pentyl, n-Pentyl, sec-Pentyl, neo-Pentyl, n-Hexyl, i-Hexyl und sec-Hexyl und insbesondere bevorzugt Alkyl ausgewählt aus der Gruppe bestehend aus Methyl, i-Propyl, t-Butyl und n-Hexyl; oder Halogen, bevorzugt Halogen ausgewählt aus der Gruppe bestehend aus F, Cl und Br, ganz besonders bevorzugt Cl.

Des Weiteren können in einer bevorzugten Ausführungsform zwei benachbarte Reste gemeinsam mit den Kohlenstoffatomen, an die sie gebunden sind, einen zyklischen Rest, bevorzugt einen 5- oder 6-gliedrigen Ring, bilden, der gesättigt oder ungesättigt sein kann, wobei unter einen ungesättigten zyklischen Rest auch ein aromatischer Rest fällt, und der substituiert oder unsubstituiert sein kann. Geeignete Substituenten sind bevorzugt ausgewählt aus der Gruppe bestehend aus Alkyl, Aryl, Alkoxy, Hydroxy, Aryloxy, Halogen, CN, SCN und NO₂, wobei Alkylreste bevorzugt sind. Geeignete Alkyl-, Aryl-, Alkoxy-, Aryloxy und Halogenreste sind bereits vorstehend genannt. Ganz besonders bevorzugt ist der zyklische Rest jedoch unsubstituiert. Beispielsweise können zwei benachbarte Reste an einem der zyklischen Liganden der Verbindung der Formel I gemeinsam mit den Kohlenstoffatomen, an die Sie gebunden sind, einen ortho-Phenylenrest bilden, so dass der cyclische Ligand ein Indenylligand ist. Es ist jedoch ebenfalls möglich, dass zweimal zwei benachbarte Reste an einem cyclischen Liganden der Verbindung der Formel I, z.B. R¹ und R² sowie R³ und R⁴ gemeinsam mit den Kohlenstoffatomen, an die sie gebunden sind, jeweils einen ortho-Phenylenrest bilden, so dass der cyclische Ligand ein Fluorenylligand ist. Im Folgenden werden alle cyclischen Liganden der Verbindung der Formel I, die auf einem zentralen Cyclopentadienylrest basieren, als Cyclopentadienylliganden bezeichnet.

Des Weiteren können R⁵ und R¹⁰ gemeinsam eine Verbrückung der allgemeinen Formel -(CR¹³R¹⁴)ₙ- bilden, wobei R¹³ und R¹⁴ jeweils unabhängig bevorzugt H oder Methyl bedeuten und n 1 oder 2, besonders bevorzugt 1 bedeutet. Das C-Atom in der Gruppe - (CR¹³R¹⁴)- kann durch ein Si-Atom ersetzt sein, das die bereits vorstehend genannten Substituenten R¹³ und R¹⁴ tragen kann. Besonders bevorzugt handelt es sich bei der Verbrückung der Formel - (CR¹³R¹⁴)ₙ- um eine Verbrückung der Formel -(CH₃)₂C-, - (CH₂)₂- oder -(CH₃)₂Si-.
Insbesondere bevorzugt sind die Reste R¹ und R⁶, R² und R⁷, R³ und R⁸, R⁴ und R⁹ sowie R⁵ und R¹⁰ jeweils identisch. Das bedeutet, dass beide Cyklopentadienylliganden in Formel I das gleiche Substitutionsmuster aufweisen.

Bei den Resten R¹¹ und R¹² handelt es sich unabhängig voneinander um Alkyl, Aryl, Alkoxy, Aryloxy, Halogen, CN, SCN, Alkylthio, Arylthio, CO, Alkinyl, Alkylamido, Arylamido, Trifluormethansulfonat oder einer der Reste R¹¹ oder R¹² bildet eine µ-oxo-Brücke zu einem weiteren Zirconocen- oder Hafnocenkomplex der Formel I aus. Bevorzugte Alkyl-, Aryl-, Alkoxy-, Aryloxy-, Alkylthio-, Arylthio- und Halogenreste sind bereits vorstehend genannt. Bevorzugt sind R¹¹ und R¹² unabhängig voneinander Alkyl, Alkoxy oder Halogen. Ganz besonders bevorzugte Reste R¹¹ und R¹² sind ausgewählt aus der Gruppe bestehend aus CH₃, OCH₃ und Cl. Insbesondere bevorzugt sind die Reste R¹¹ und R¹² identisch. Des Weiteren können R¹¹ und R¹² gemeinsam einen zweizähnigen Liganden bilden. Geeignete zweizähnige Liganden wurden bereits vorstehend genannt. Ganz besonders bevorzugt sind R¹¹ und R¹² Cl.

In einer bevorzugten Ausführungsform betrifft die vorliegende Anmeldung die Verwendung von Verbindungen der Formel I, worin die Symbole die folgenden Bedeutungen aufweisen:
- R¹ R², R³ R⁴, R⁵ R⁶, R⁷, R⁸, R⁹, R¹⁰: unabhängig voneinander H, Alkyl, Aryl oder Halogen;
oder
zwei benachbarte Reste bilden gemeinsam mit den Kohlenstoffatomen, an die sie gebunden sind, einen ortho-Phenylenrest;
und/oder
- R⁵ und R¹⁰: bilden gemeinsam eine Verbrückung der allgemeinen Formel -(CR¹³R¹⁴)ₙ-, wobei R¹³ und R¹⁴ jeweils Methyl bedeuten und n 1 bedeutet und das C-Atom durch Si ersetzt sein kann;
- R¹¹, R¹²: unabhängig voneinander Alkyl, Alkoxy, Alkylthio, Arylthio oder Halogen.

Bevorzugte Reste R¹ R², R³, R⁴, R⁵, R⁶, R⁷, R⁸, R⁹ und R¹⁰ sowie bevorzugte Reste R¹¹, R¹² und R¹³ und R¹⁴ sind bereits vorstehend genannt.

Insbesondere bevorzugt verwendete Zirconocenkomplexe der Formel I sind nachstehend aufgeführt, wobei M Zr bedeutet und rac die racemische Form des entsprechenden Komplexes ist und meso die meso-Form des Komplexes bedeutet.

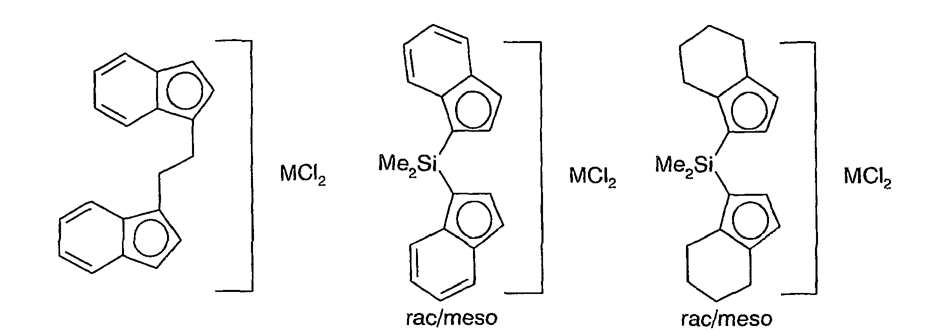

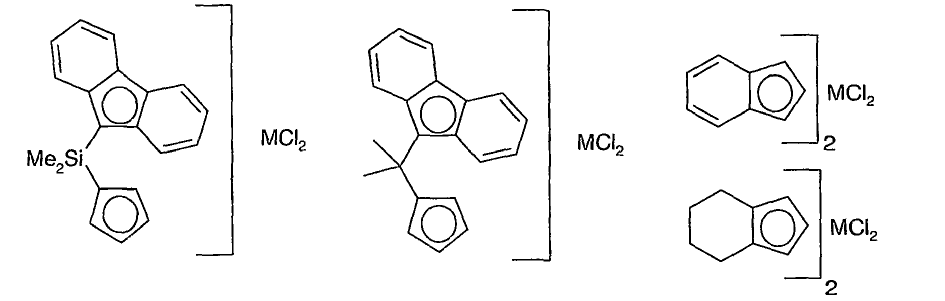

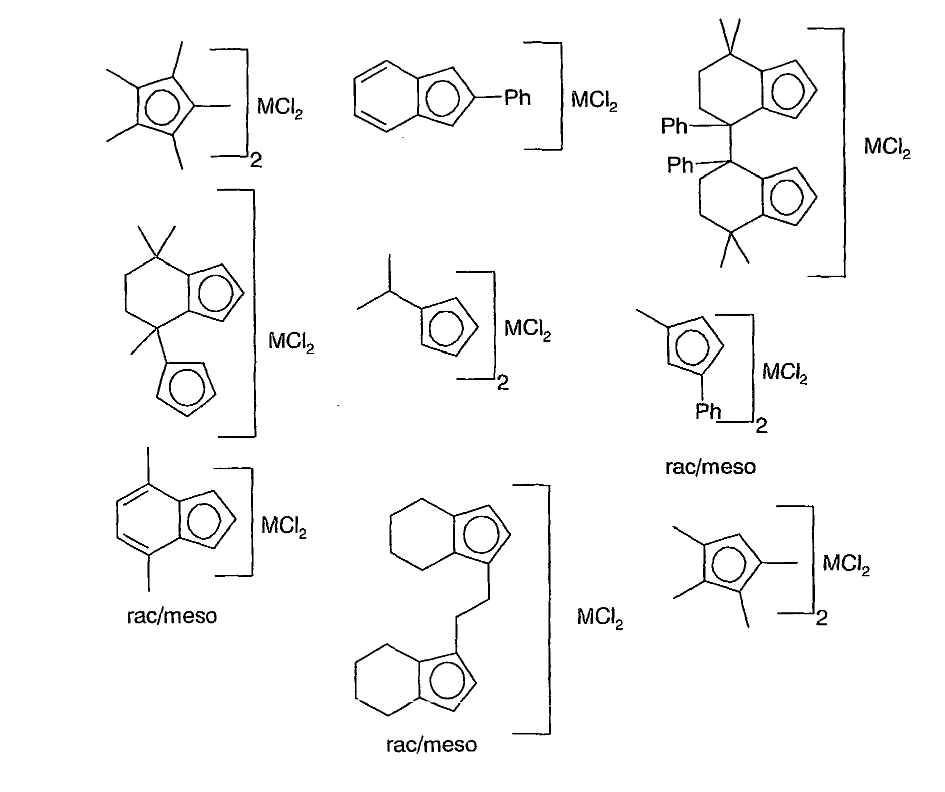

Die vorstehend genannten neutralen Zirconocenkomplexe sind hervorragend als Emittermoleküle in organischen Licht-emittierenden Dioden (OLEDs) geeignet. Durch einfache Variationen der Liganden ist es möglich, Zirconocenkomplexe bereit zu stellen, die Elektrolumineszenz im roten, grünen sowie insbesondere im blauen Bereich des elektromagnetischen Spektrums zeigen. Die erfindungsgemäß verwendeten neutralen Zirconocenkomplexe eignen sich daher für den Einsatz in technisch verwendbaren Vollfarbendisplays.

Die Herstellung der Zirconocenkomplexe erfolgt nach dem Fachmann bekannten Verfahren. Einige der erfindungsgemäß verwendeten Zirconocenkomplexe sind des Weiteren kommerziell erhältlich.

Ein übliches Verfahren zur Herstellung ist zum Beispiel die Deprotonierung von den den Cyclopentadienylliganden der Verbindungen der Formel I entsprechenden Ligandvorläufern und anschließende, im Allgemeinen in situ, Umsetzung mit geeigneten Zirconium enthaltenden Metallkomplexen. Die geeigneten Zirconium enthaltenden Metallkomplexe sind im Allgemeinen kommerziell erhältlich oder nach dem Fachmann bekannten Verfahren herstellbar und enthalten bevorzugt Reste der Gruppen R¹¹ und R¹². Somit sind bevorzugte Zirconium enthaltende Metallkomplexe z.B. ZrCl₄, die THF-Addukte von ZrCl₄, CpZrCl₃.

Alternativ können auch die den Cyclopentadienylliganden der Verbindungen der Formel I entsprechenden Ligandvorläufer mit Zirconium enthaltenden Basen, zum Beispiel Zr(NEt₂)₄ nach dem Fachmann bekannten Verfahren umgesetzt werden.

Geeignete Ligandvorläufer, die zu den Cyclopentadienylliganden der Zirconocenkomplexe der Formel I führen, sind dem Fachmann bekannt und sind kommerziell erhältlich bzw. nach dem Fachmann bekannten Verfahren herstellbar.

Erfolgt eine Deprotonierung der Liganden, so kann diese durch Alkalimetalle, insbesondere in fein verteilter Form, basische Metallate, basische Anionen wie Metallacetate, Acetylacetonate oder Alkoxylate oder externe Basen wie KO^{t}Bu, NaO^{t}Bu, LiO^{t}Bu, NaH, Metallalkyle wie Butyllithium, Methyllithium, Silylamide, Li-Hexamethyldisilazid, sowie Phosphazenbasen erfolgen.

Die Umsetzung erfolgt bevorzugt in einem Lösungsmittel. Geeignete Lösungsmittel sind aprotische Lösungsmittel, die dem Fachmann bekannt sind, und bevorzugt ausgewählt sind aus aromatischen und aliphatischen Lösungsmitteln. Besonders bevorzugt werden aromatische Lösungsmittel wie Toluol und Benzol, Ether wie Tetrahydrofuran, tert.-Butylether, und tert.-Butylmethylether, sowie halogenierte Kohlenwasserstoffe wie Methylenchorid eingesetzt.

Das molare Verhältnis von eingesetztem Zirconium enthaltenden Metallkomplex zu eingesetztem Ligandvorläufer beträgt bevorzugt 0,7 : 2,0 bis 1,5 : 2,0, besonders bevorzugt 0,9 : 2,0 bis 1,1 : 2, ganz besonders bevorzugt 1 : 2 bei Liganden, die keine Verbrückung aufweisen. Bei Liganden, die eine Verbrückung aufweisen, beträgt das molare Verhältnis bevorzugt 0,7 : 1,0 bis 1,5 : 1,0, besonders bevorzugt 0,9 : 1,0 bis 1,1 : 1,0, ganz besonders bevorzugt 1 : 1.

Die Umsetzung erfolgt im Allgemeinen bei Temperaturen von -100°C bis +200°C, bevorzugt -100°C bis +100°C, besonders bevorzugt -78°C bis +50°C.

Die Reaktionsdauer ist abhängig von dem gewünschten Zirconocenkomplex und beträgt im Allgemeinen von 1 h bis 50 h, bevorzugt 2 h bis 30 h, besonders bevorzugt 5 h bis 25 h.

Der erhaltene Zirconocenkomplex der Formel I wird nach dem Fachmann bekannten Methoden aufgearbeitet. Beispielsweise wird der entstandene Zirconocenkomplex aus der Reaktionslösung mit einem unpolaren Lösungsmittel, z.B. n-Pentan oder n-Hexan ausgefällt, filtriert, gewaschen, zum Beispiel mit dem zum Ausfällen verwendeten Lösungsmittel, und anschließend getrocknet. Durch Umkristallisation, zum Beispiel aus Dichlormethan, Diethylether, Dichlorethan oder Gemischen davon, werden hochreine Zirconocen komplexe erhalten.

Die erfindungsgemäß verwendeten Zirconocenkomplexe der Formel I eignen sich hervorragend als Emittersubstanzen, da sie eine Emission (Elektrolumineszenz) im sichtbaren Bereich des elektromagnetischen Spektrums aufweisen. Mit Hilfe der erfindungsgemäß verwendeten Zirconocenkomplexe als Emittersubstanzen ist es möglich, Verbindungen bereit zu stellen, die Elektrolumineszenz im roten, grünen sowie im blauen Bereich des elektromagnetischen Spektrums aufweisen. Somit ist es möglich mit Hilfe der erfindungsgemäß verwendeten Zirconocenkomplexe als Emittersubstanzen technisch einsetzbare Vollfarbendisplays bereit zu stellen. Des Weiteren eignen sich die Zirconocenkomplexe als Lochblocker, zum Beispiel in einer Blockschicht für Löcher in einem OLED, die zwischen der Licht-emittierenden Schicht und einer Elektronen-transprotierenden Schicht des OLEDs angeordnet ist. Die Anwendung der erfindungsgemäß verwendeten Zirconocenkomplexe in den verschiedenen Schichten ist abhängig von der Lage des HOMO der Metallocenkomplexe und somit von dem Substitutionsmuster der Metallocenkomplexe.

Eine besondere Eigenschaft der Zirconocenkomplexe der Formel I ist, dass diese im Festkörper Lumineszenz, besonders bevorzugt Elektrolumineszenz, im sichtbaren Bereich des elektromagnetischen Spektrums zeigen. Diese im Festkörper lumineszierenden Komplexe können in Substanz, also ohne weitere Zusätze, als Emittersubstanzen in OLEDs eingesetzt werden. Dadurch kann ein OLED mit einer Licht-emittierenden Schicht hergestellt werden, wobei keine aufwendige Coverdampfung eines Matrixmaterials mit der Emittersubstanz erforderlich ist.

Ein weiterer Gegenstand der vorliegenden Anmeldung sind daher organische Leuchtdioden (OLEDs) enthaltend mindestens einen Zirconocenkomplex der Formel I.

Organische Leuchtdioden sind grundsätzlich aus mehreren Schichten aufgebaut:
1. Anode
2. Löcher-transportierende Schicht
3. Licht-emittierende Schicht
4. Elektronen-transportierende Schicht
5. Kathode

Die Zirconocenkomplexe können in verschiedenen Schichten des OLEDs eingesetzt werden, in Abhängigkeit von der Lage ihres HOMO, zum Beispiel können die Zirconocenkomplexe als Lochblocker in einer Blockschicht für Löcher oder als Emittermoleküle in der Licht-emittierenden Schicht eingesetzt werden.

Bevorzugt werden sie in der Licht-emittierenden Schicht als Emittermoleküle eingesetzt. Ein weiterer Gegenstand der vorliegenden Anmeldung ist daher eine Licht-emittierende Schicht enthaltend mindestens einen Zirconocenkomplex. Bevorzugte Zirconocenkomplexe, sind bereits vorstehend genannt.

Die erfindungsgemäß verwendeten Zirconocenkomplexe können in Substanz - ohne weitere Zusätze - in der Licht-emittierenden Schicht vorliegen. Es ist jedoch ebenfalls möglich, dass neben den erfindungsgemäß eingesetzten Zirconocenkomplexen weitere Verbindungen in der Licht-emittierenden Schicht vorliegen. Beispielsweise kann ein fluoreszierender Farbstoff anwesend sein, um die Emissionsfarbe des als Emittermolekül eingesetzten Zirconocenkomplexes zu verändern. Des Weiteren kann ein Verdünnungsmaterial eingesetzt werden. Dieses Verdünnungsmaterial kann ein Polymer sein, zum Beispiel Poly(N-vinylcarbazol) oder Polysilan. Das Verdünnungsmaterial kann jedoch ebenfalls ein kleines Molekül sein, zum Beispiel 4,4'-N,N'-Dicarbazolbiphenyl (CBP), Tetraarylsilan oder tertiäre aromatische Amine. Wenn ein Verdünnungsmaterial eingesetzt wird, beträgt der Anteil der erfindungsgemäß eingesetzten Zirconocenkomplexe in der Licht-emittierenden Schicht im Allgemeinen weniger als 20 Gew.-%, bevorzugt 3 bis 10 Gew.-%. Bevorzugt werden die Zirconocenkomplexe in Substanz eingesetzt, wodurch eine aufwendige Coverdampfung der Zirconocenkomplexe mit einem Matrixmaterial (Verdünnungsmaterial oder fluoreszierender Farbstoff) vermieden wird. Dafür ist es wesentlich, dass die Zirconocenkomplexe im Festkörper lumineszieren. Die Zirconocenkomplexe zeigen im Festkörper Lumineszenz. Somit enthält die Licht-emittierende Schicht bevorzugt mindestens einen Zirconocenkomplex und kein Matrixmaterial ausgewählt aus Verdünnungsmaterial und fluoreszierendem Farbstoff.

Ein weiterer Gegenstand der vorliegenden Anmeldung ist in einer weiteren Ausführungsform eine Licht-emittierende Schicht bestehend aus mindestens einem Zirconocenkomplex. Bevorzugte Komplexe wurden bereits vorstehend genannt.

Die einzelnen der vorstehend genannten Schichten des OLEDs können wiederum aus 2 oder mehreren Schichten aufgebaut sein. Beispielsweise kann die Löcher-transportierende Schicht aus einer Schicht aufgebaut sein, in die aus der Elektrode Löcher injiziert werden und einer Schicht, die die Löcher von der Loch injizierenden Schicht weg in die Licht-emittierende Schicht transportiert. Die Elektronen-transportierende Schicht kann ebenfalls aus mehreren Schichten bestehen, zum Beispiel einer Schicht, worin Elektronen durch die Elektrode injiziert werden, und einer Schicht, die aus der Elektronen-injizierenden Schicht Elektronen erhält und in die Licht-emittierende Schicht transportiert. Diese genannten Schichten werden jeweils nach Faktoren wie Energieniveau, Temperaturresistenz und Ladungsträgerbeweglichkeit, sowie Energiedifferenz der genannten Schichten mit den organischen Schichten oder den Metallelektroden ausgewählt. Der Fachmann ist in der Lage, den Aufbau der OLEDs so zu wählen, dass er optimal an die erfindungsgemäß als Emittersubstanzen verwendeten Zirconocenkomplexe angepasst ist.

Um besonders effiziente OLEDs zu erhalten, sollte das HOMO (höchstes besetztes Molekülorbital) der Loch-transportierenden Schicht mit der Arbeitsfunktion der Anode angeglichen sein und das LUMO (niedrigstes unbesetztes Molekülorbital) der elektronentransportierenden Schicht sollte mit der Arbeitsfunktion der Kathode angeglichen sein.

Ein weiterer Gegenstand der vorliegenden Anmeldung ist ein OLED enthaltend mindestens eine erfindungsgemäße Licht-emittierende Schicht. Die weiteren Schichten in dem OLED können aus einem beliebigen Material aufgebaut sein, das üblicherweise in solchen Schichten eingesetzt wird und dem Fachmann bekannt ist.

Die Anode (1) ist eine Elektrode, die positive Ladungsträger bereitstellt. Sie kann zum Beispiel aus Materialien aufgebaut sein, die ein Metall, eine Mischung verschiedener Metalle, eine Metalllegierung, ein Metalloxid oder eine Mischung verschiedener Metalloxide enthält. Alternativ kann die Anode ein leitendes Polymer sein. Geeignete Metalle umfassen die Metalle der Gruppen Ib, IVa, Va und VIa des Periodensystems der Elemente sowie die Übergangsmetalle der Gruppe VIII. Wenn die Anode lichtdurchlässig sein soll, werden im Allgemeinen gemischte Metalloxide der Gruppen IIb, IIIb und IVb des Periodensystems der Elemente eingesetzt, zum Beispiel Indium-Zinn-Oxid (I-TO). Es ist ebenfalls möglich, dass die Anode (1) ein organisches Material, zum Beispiel Polyanilin enthält, wie beispielsweise in Nature, Vol. 357, Seiten 477 bis 479 (11. Juni 1992) beschrieben ist. Zumindest entweder die Anode oder die Kathode sollten mindestens teilweise transparent sein, um das gebildete Licht auskoppeln zu können.

Geeignete Lochtransportmaterialien für die Schicht (2) des erfindungsgemäßen OLEDs sind zum Beispiel in Kirk-Othmer Encyclopedia of Chemical Technologie, 4. Auflage, Vol. 18, Seiten 837 bis 860, 1996 offenbart. Sowohl Löcher transportierende Moleküle als auch Polymere können als Lochtransportmaterial eingesetzt werden. Üblicherweise eingesetzte Löcher transportierende Moleküle sind ausgewählt aus der Gruppe bestehend aus 4,4'-Bis[N-(1-naphthyl)-N-phenyl-amino]biphenyl (□-NPD), N,N'-Diphenyl-N, N'-bis(3-methylphenyl)-[1,1'-biphenyl]-4,4'-diamin (TPD), 1,1-Bis[(di-4-tolylamino)phenyl]cyclohexan (TAPC), N,N'-Bis(4-methylphenyl)-N,N'-bis(4-ethylphenyl)-[1,1'-(3,3'-dimethyl)biphenyl]-4,4'-diamin (ETPD), Tetrakis-(3-methylphenyl)-N,N,N',N'-2,5-phenylendiamin (PDA), α-Phenyl-4-N,N-diphenylaminostyrol (TPS), p-(Diethylamino)-benzaldehyddiphenylhydrazon (DEH), Triphenylamin (TPA), Bis[4-(N,N-diethylamino)-2-methylphenyl)](4-methyl-phenyl)methan (MPMP), 1-Phenyl-3-[p-(diethylamino)styryl]-5-[p-(diethylamino)phenyl]pyrazolin (PPR oder DEASP), 1,2-trans-Bis(9H-carbazol-9-yl)cyclobutan (DCZB), N,N,N',N'-Tetrakis(4-methylphenyl)-(1,1'-biphenyl)-4,4'-diamin (TTB) und Porphyrinverbindungen wie Kupferphthalocyanine. Üblicherweise eingesetzte Löcher transportierende Polymere sind ausgewählt aus der Gruppe bestehend aus Polyvinylcarbazolen, (Phenylmethyl)polysilanen und Polyanilinen. Es ist ebenfalls möglich, Löcher transportierende Polymere durch Dotieren Löcher transportierender Moleküle in Polymere wie Polystyrol und Polycarbonat zu erhalten. Geeignete Löcher transportierende Moleküle sind die bereits vorstehend genannten Moleküle.

Geeignete Elektronen transportierende Materialien für die Schicht (4) der erfindungsgemäßen OLEDs umfassen mit oxinoiden Verbindungen chelatisierte Metalle wie Tris(8-chinolinolato)aluminium (Alq₃), Verbindungen auf Phenanthrolinbasis wie 2,9-Dimethyl,4,7-diphenyl-1,10-phenanthrolin (DDPA) oder 4,7-Diphenyl-1,10-phenanthrolin (DPA) und Azolverbindungen wie 2-(4-Biphenylyl)-5-(4-t-butylphenyl)-1,3,4-oxadiazol (PBD) und 3-(4-Biphenylyl)-4-phenyl-5-(4-t-butylphenyl)-1,2,4-triazol (TAZ). Dabei kann die Schicht (4) sowohl zur Erleichterung des Elektronentransports dienen als auch als Pufferschicht oder als Sperrschicht, um ein Quenchen des Excitons an den Grenzflächen der Schichten des OLEDs zu vermeiden. Vorzugsweise verbessert die Schicht (4) die Beweglichkeit der Elektronen und reduziert ein Quenchen des Excitons.

Die Kathode (5) ist eine Elektrode, die zur Einführung von Elektronen oder negativen Ladungsträgern dient. Die Kathode kann jedes Metall oder Nichtmetall sein, das eine geringere Arbeitsfunktion aufweist als die Anode. Geeignete Materialien für die Kathode sind ausgewählt aus der Gruppe bestehend aus Alkalimetallen der Gruppe Ia, zum Beispiel Li, Cs, Erdalkalimetallen der Gruppe IIa, Metallen der Gruppe IIb des Periodensystems der Elemente, und den Seltenerdmetalle und die Lanthanide und Aktinide. Des Weiteren können Metalle wie Aluminium, Indium, Calcium, Barium, Samarium und Magnesium sowie Kombinationen davon eingesetzt werden. Weiterhin können Lithium enthaltende organometallische Verbindungen oder LiF zwischen der organischen Schicht und der Kathode aufgebracht werden, um die Betriebsspannung (Operating Voltage) zu vermindern.

Das OLED gemäß der vorliegenden Erfindung kann zusätzlich weitere Schichten enthalten, die dem Fachmann bekannt sind. Beispielsweise kann zwischen der Schicht (2) und der Licht emittierenden Schicht (3) eine Schicht aufgebracht sein, die den Transport der positiven Ladung erleichtert und/oder die Bänderlücke der Schichten aneinander anpasst. Alternativ kann diese weitere Schicht als Schutzschicht dienen. In analoger Weise können zusätzliche Schichten zwischen der Licht emittierenden Schicht (3) und der Schicht (4) vorhanden sein, um den Transport der negativen Ladung zu erleichtern und/oder die Bänderlücke zwischen den Schichten aneinander anzupassen. Alternativ kann diese Schicht als Schutzschicht dienen.

In einer bevorzugten Ausführungsform enthält das erfindungsgemäße OLED zusätzlich zu den Schichten (1) bis (5) mindestens eine der im Folgenden genannten weiteren Schichten:
- eine Loch-Injektionsschicht zwischen der Anode (1) und der Löcher-transportierenden Schicht (2);
- eine Blockschicht für Elektronen zwischen der Löcher-transportierenden Schicht (2) und der Licht-emittierenden Schicht (3);
- eine Blockschicht für Löcher zwischen der Licht-emittierenden Schicht (3) und der Elektronen-transportierenden Schicht (4);
- eine Elektronen-Injektionsschicht zwischen der Elektronen-transportierenden Schicht (4) und der Kathode (5).

Dem Fachmann ist bekannt, wie er (zum Beispiel auf Basis von elektrochemischen Untersuchungen) geeignete Materialien auswählen muss. Geeignete Materialien für die einzelnen Schichten sind dem Fachmann bekannt und z.B. in WO 00/70655 offenbart.

Des Weiteren kann jede der genannten Schichten des erfindungsgemäßen OLEDs aus zwei oder mehreren Schichten ausgebaut sein. Des Weiteren ist es möglich, dass einige oder alle der Schichten (1), (2), (3), (4) und (5) oberflächenbehandelt sind, um die Effizienz des Ladungsträgertransports zu erhöhen. Die Auswahl der Materialien für jede der genannten Schichten ist bevorzugt dadurch bestimmt, ein OLED mit einer hohen Effizienz zu erhalten.

Die Herstellung des erfindungsgemäßen OLEDs kann nach dem Fachmann bekannten Methoden erfolgen. Im Allgemeinen wird das OLED durch aufeinanderfolgende Dampfabscheidung (Vapor deposition) der einzelnen Schichten auf ein geeignetes Substrat hergestellt. Geeignete Substrate sind zum Beispiel Glas oder Polymerfilme. Zur Dampfabscheidung können übliche Techniken eingesetzt werden wie thermische Verdampfung, Chemical Vapor Deposition und andere. In einem alternativen Verfahren können die organischen Schichten aus Lösungen oder Dispersionen in geeigneten Lösungsmitteln beschichtet werden, wobei dem Fachmann bekannte Beschichtungstechniken angewendet werden.

Im Allgemeinen haben die verschiedenen Schichten folgende Dicken: Anode (2) 500 bis 5000 Å (1Å=0.1 nm), bevorzugt 1000 bis 2000 Å; Löcher-transportierende Schicht (3) 50 bis 1000 Å, bevorzugt 200 bis 800 Å, Licht-emittierende Schicht (4) 10 bis 1000 Å, bevorzugt 100 bis 800 Å, Elektronen transportierende Schicht (5) 50 bis 1000 Å, bevorzugt 200 bis 800 Å, Kathode (6) 200 bis 10.000 Å, bevorzugt 300 bis 5000 Å. Die Lage der Rekombinationszone von Löchern und Elektronen in dem erfindungsgemäßen OLED und somit das Emissionsspektrum des OLED können durch die relative Dicke jeder Schicht beeinflusst werden. Das bedeutet, die Dicke der Elektronentransportschicht sollte bevorzugt so gewählt werden, dass die Elektronen/Löcher Rekombinationszone in der Licht-emittierenden Schicht liegt. Das Verhältnis der Schichtdicken der einzelnen Schichten in dem OLED ist von den eingesetzten Materialien abhängig. Die Schichtdicken von gegebenenfalls eingesetzten zusätzlichen Schichten sind dem Fachmann bekannt.

Durch Einsatz der erfindungsgemäß verwendeten Zirconocenkomplexe als Emittermolekül in der Licht-emittierenden Schicht der erfindungsgemäßen OLEDs können OLEDs mit hoher Effizienz erhalten werden. Die Effizienz der erfindungsgemäßen OLEDs kann des Weiteren durch Optimierung der anderen Schichten verbessert werden. Beispielsweise können hoch effiziente Kathoden wie Ca, Ba oder LiF eingesetzt werden. Geformte Substrate und neue Löcher-transportierende Materialien, die eine Reduktion der Operationsspannung oder eine Erhöhung der Quanteneffizienz bewirken, sind ebenfalls in den erfindungsgemäßen OLEDs einsetzbar. Des Weiteren können zusätzliche Schichten in den OLEDs vorhanden sein, um die Energielevel der verschiedenen Schichten einzustellen und um Elektrolumineszenz zu erleichtern.

Die erfindungsgemäßen OLEDs können in allen Vorrichtungen eingesetzt werden, worin Elektrolumineszenz nützlich ist. Geeignete Vorrichtungen sind bevorzugt ausgewählt aus stationären und mobilen Bildschirmen. Stationäre Bildschirme sind z.B. Bildschirme von Computern, Fernsehern, Bildschirme in Druckern, Küchengeräten sowie Reklametafeln, Beleuchtungen und Hinweistafeln. Mobile Bildschirme sind z.B. Bildschirme in Handys, Laptops, Fahrzeugen sowie Zielanzeigen an Bussen und Bahnen.

Weiterhin können die erfindungsgemäß eingesetzten Zirconocenkomplexe in OLEDs mit inverser Struktur eingesetzt werden. Bevorzugt werden die Zirconocenkomplexe in diesen inversen OLEDs wiederum in der Licht-emittierenden Schicht, besonders bevorzugt als Licht-emittierende Schicht ohne weitere Zusätze, eingesetzt. Der Aufbau von inversen OLEDs und die üblicherweise darin eingesetzten Materialien sind dem Fachmann bekannt.

### Beispiele

### Beispiel 1

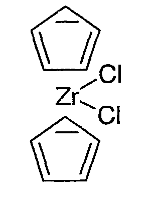

Zirkonocendichlorid ist kommerziell erhältlich.
UV/Vis (Pulver): □_{max,em} = 451 nm

### Beispiel 2 (nicht gemäß der Erfindung)

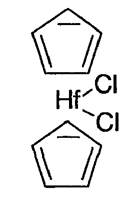

Hafnocendichlorid ist kommerziell erhältlich.
UV/Vis (Pulver): □_{max,em} = 449 nm

### Beispiel 3:

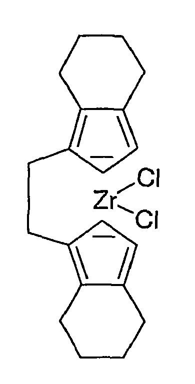

rac-Ethylenbis(4,5,6,7-tetrahydro-1-indenyl)zirkoniumdichlorid ist kommerziell erhältlich.
UV/V is (Pulver) : □_{max,em} = 458 nm

## Patentansprüche

1. Verwendung von Zirconocenkomplex-en der Formel I 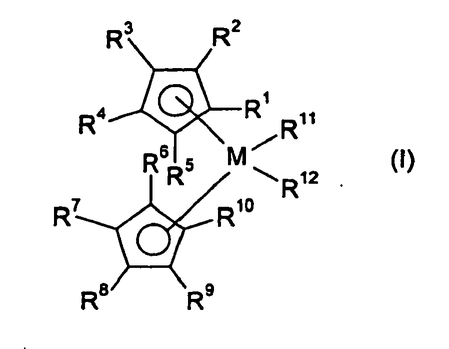 worin die Symbole die folgenden Bedeutungen aufweisen:
R¹ R², R³, R⁴, R⁵, R⁶, R⁷, R⁸, R⁹, R¹⁰ unabhängig voneinander H, Alkyl, Aryl, Alkoxy, Hydroxy, Aryloxy, Halogen, CN, SCN, NO₂, CR¹⁷R¹⁸NR²⁰, CF₃; wobei R¹⁷, R¹⁸, R¹⁹, R²⁰ jeweils unabhängig voneinander H, Alkyl oder Aryl bedeuten;
oder
zwei benachbarte Reste bilden gemeinsam mit den Kohlenstoffatomen, an die sie gebunden sind, einen zyklischen Rest, der gesättigt oder ungesättigt und substituiert oder unsubstituiert sein kann und gegebenenfalls ein oder mehrere Heteroatome enthalten kann;
und/oder
R⁵ und R¹⁰ bilden gemeinsam eine Verbrückung, die die allgemeine Formel - (CR¹³R¹⁴)ₙ- aufweist, wobei R¹³ und R¹⁴ jeweils unabhängig voneinander H, Alkyl oder Aryl bedeuten, n 1 bis 2 bedeutet und die Reste R¹³ und R¹⁴ in den n Gruppen -(CR¹³R¹⁴)- gleich oder verschieden sein können und in einer oder mehreren der Gruppen -(CR¹³R¹⁴)- das Kohlenstoffatom durch Si oder B ersetzt sein kann;
R¹¹, R¹² unabhängig voneinander Alkyl ausgewählt aus der Gruppe bestehend aus Methyl, Ethyl, i-Propyl, n*-*Propyl*,* i-Butyl, n-Butyl, t-Butyl, sec-Butyl, i-Pentyl, n-Pentyl, sec-Pentyl, neo-Pentyl, n-Hexyl, i-Hexyl, sec-Hexyl, Cyclohexyl und Cyclopentyl, Aryl, Alkoxy, Aryloxy, Halogen, CN, SCN, CO, Alkinyl, Alkylthio, Arylthio, Alkylamido, Arylamido, Trifluormethansulfonat oder einer der Reste bildet eine µ-oxo-Brücke zu einem weiteren Zirconocen- oder Hafnocenkomplex der Formel I aus;
oder
R¹¹ und R¹² bilden gemeinsam einen zweizähnigen Liganden;
M Zr;
in organischen Leuchtdioden.

2. Verwendung nach Anspruch 1, **dadurch gekennzeichnet, dass**
R¹, R², R³, R⁴, R⁵, R⁶, R⁷, R⁸, R⁹, R¹⁰ unabhängig voneinander H, Alkyl, Aryl oder Halogen bedeuten,
oder
zwei benachbarte Reste gemeinsam mit den Kohlenstoff atomen, an die sie gebunden sind, einen ortho-Phenylenrest bilden;
und/oder
R⁵ und R¹⁰ gemeinsam eine Verbrückung der allgemeinen Formel - (CR¹³R¹⁴)ₙ- bilden, wobei R¹³ und R¹⁴ jeweils Methyl bedeuten und n 1 bedeutet und das C-Atom durch Si ersetzt sein kann;
R¹¹, R¹² unabhängig voneinander Alkyl ausgewählt aus der Gruppe bestehend aus Methyl, Ethyl, i-Propyl, n-Propyl, i-Butyl, n-Butyl, t-Butyl, sec-Butyl, i-Pentyl, n-Pentyl, sec-Pentyl, neo-Pentyl, n-Hexyl, i-Hexyl, sec-Hexyl, Cyclohexyl und Cyclopentyl, Alkoxy, Alkylthio, Arylthio oder Halogen bedeuten.

3. Verwendung nach Anspruch 1 oder 2, **dadurch gekennzeichnet, dass** die Zirconocenkomplexe ausgewählt sind aus der Gruppe bestehend aus 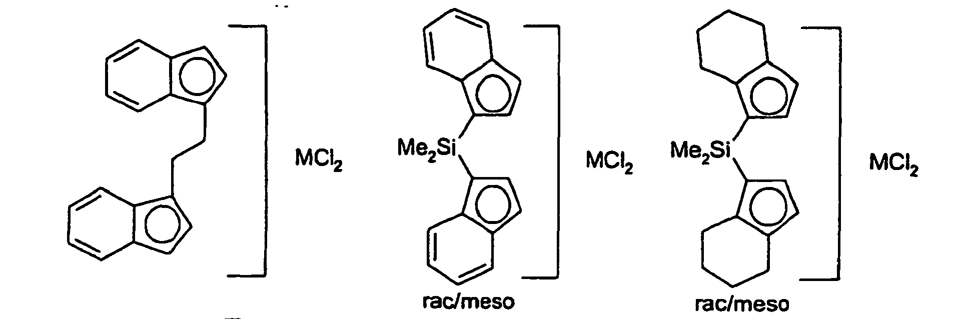 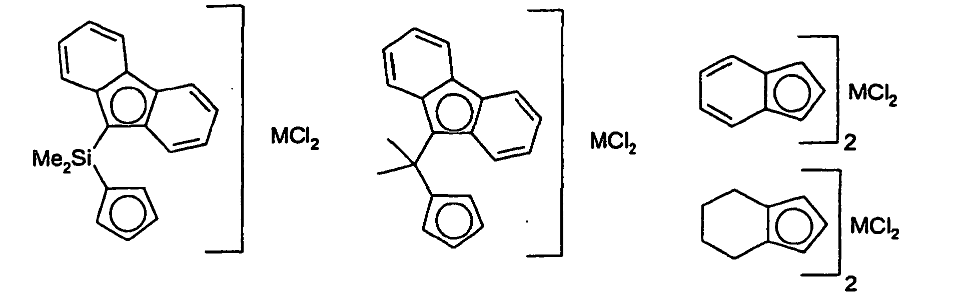 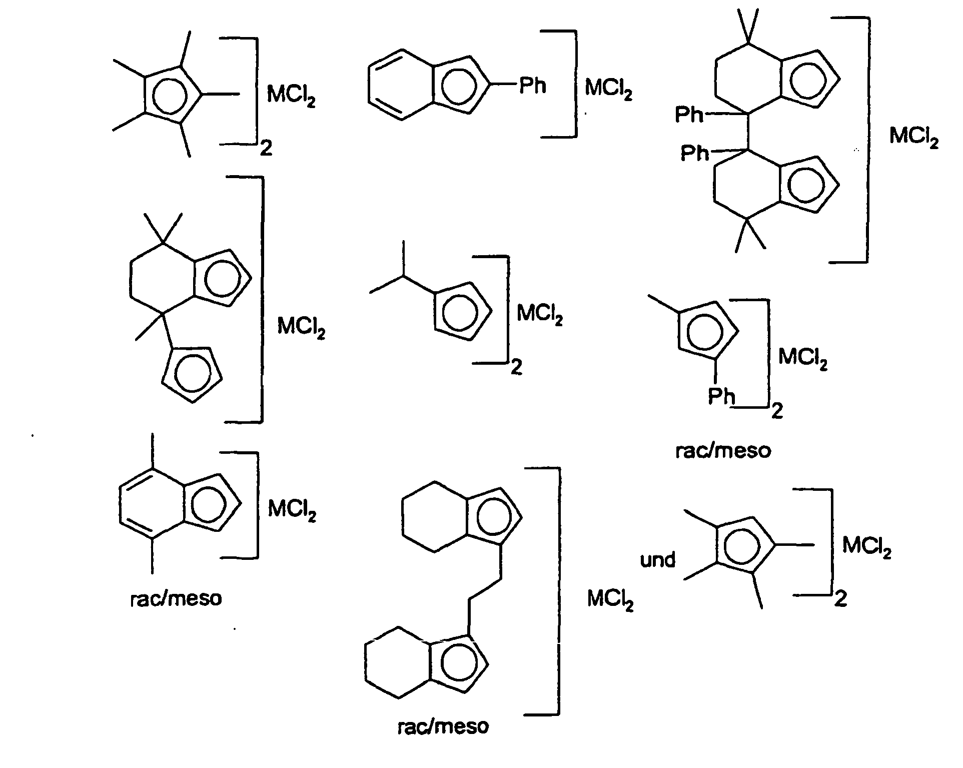 worin M Zr und rac die racemische Form des entsprechenden Komplexes und meso die meso-Form des entsprechenden Metallkomplexes bedeutet.

4. Verwendung nach einem der Ansprüche 1 bis 3, **dadurch gekennzeichnet, dass** die Metallocenkomplexe als Emittermoleküle in den OLEDs eingesetzt werden.

5. OLED enthaltend mindestens einen Zirconocenkomplex gemäß einem der Ansprüche 1 bis 4.

6. Licht-emittierende Schicht enthaltend mindestens einen Zirconocenkomplex gemäß einem der Ansprüche 1 bis 4.

7. Licht-emittierende Schicht bestehend aus mindestens einem Zirconocenkomplex gemäß einem der Ansprüche 1 bis 4.

8. OLED enthaltend eine Licht-emittierende Schicht gemäß Anspruch 6 oder 7.

9. Vorrichtung ausgewählt aus der Gruppe bestehend aus stationären Bildschirmen wie Bildschirmen von Computern, Fernsehern, Bildschirmen in Druckern, Küchengeräten sowie Reklametafeln, Beleuchtungen, Hinweistafeln und mobilen Bildschirmen wie Bildschirmen in Handys, Laptops, Farbfernsehern sowie Zielanzeigen an Bussen und Bahnen enthaltend ein OLED gemäß Anspruch 5 oder 8.

## Claims

1. The use of zirconocene complexes of the formula I 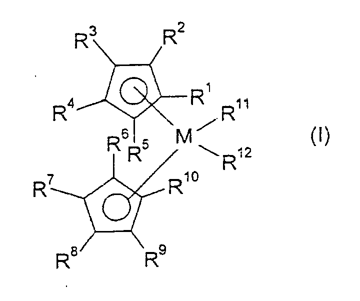 where the symbols have the following meanings:
R¹, R² , R³, R⁴ , R⁵, R⁶, R⁷, R⁸, R⁹, R¹⁰ are each, independently of one another, H, alkyl, aryl, alkoxy, hydroxy, aryloxy, halogen, CN, SCN, NO₂ CR¹⁷R¹⁸NR¹⁹R²⁰ CF₃; where R¹⁷ R¹⁸, R¹⁹, R²⁰ are each, independently of one another, H,alkyl or aryl;
or
two adjacent radicals together with the carbon atoms to which they are bound form a cyclic radical which may be saturated or unsaturated and substituted or unsubstituted and may contain one or more heteroatoms;
and/or
R⁵ and R¹⁰ together form a bridge having the general formula - (CR¹³R¹⁴)ₙ-, where R¹³ and R¹⁴ are each, independently of one another, H, alkyl or aryl, n is 1 or 2 and the radicals R¹³ and R¹⁴ in the n groups - (CR¹³R¹⁴) - can be identical or different and the carbon atom can be replaced by Si or B in one or more of the groups - (CR¹³R¹⁴) -;
R¹¹, R¹² are each, independently of one another, alkyl selected from the group consisting of methyl, ethyl, i-propyl, n-propyl, i-butyl, n-butyl, t-butyl, sec-butyl, i-pentyl, n-pentyl, sec-pentyl, neopentyl, n-hexyl, i-hexyl, sec-hexyl, cyclohexyl and cyclopentyl, aryl, alkoxy, aryloxy, halogen, CN, SCN, CO, alkynyl, alkylthio, arylthio, alkylamido, arylamido, trifluoromethanesulfonate or one of the radicals forms a µ-oxo bridge to a further zirconocene or hafnocene complex of the formula I;
or
R¹¹ and R¹² together form a bidentate ligand;
M is Zr;
are used in organic light-emitting diodes.

2. The use according to claim 1, wherein
R¹, R², R³, R⁴, R⁵, R⁶, R⁷, R⁸, R⁹, R¹⁰ are each, independently of one another, H, alkyl, aryl or halogen;
or
two adjacent radicals together with the carbon atoms to which they are bound form an ortho-phenylene radical;
and/or
R⁵ and R¹⁰ together form a bridge of the general formula - (CR¹³R¹⁴)ₙ-, where R¹³ and R¹⁴ are each methyl and n is 1 and the carbon atom may be replaced by Si;
R¹¹, R¹² are each, independently of one another, alkyl selected from the group consisting of methyl, ethyl, i-propyl, n-propyl, i-butyl, n-butyl, t-butyl, sec-butyl, i-pentyl, n-pentyl, sec-pentyl, neopentyl, n-hexyl, i-hexyl, sec-hexyl, cyclohexyl and cyclopentyl, alkoxy, alkylthio, arylthio or halogen.

3. The use according to claim 1 or 2, wherein the zirconocene complexes are selected from the group consisting of 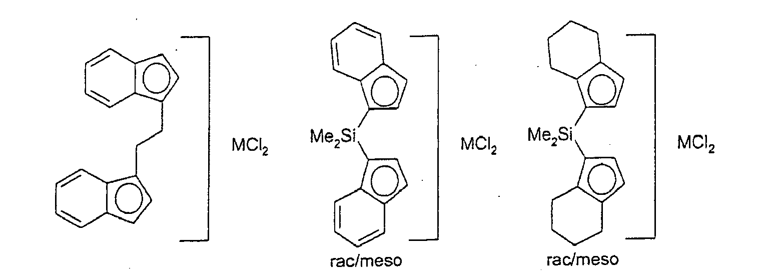 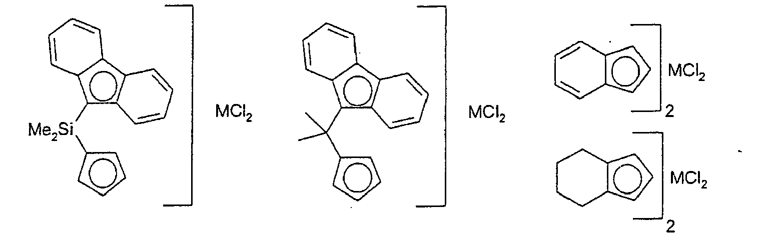 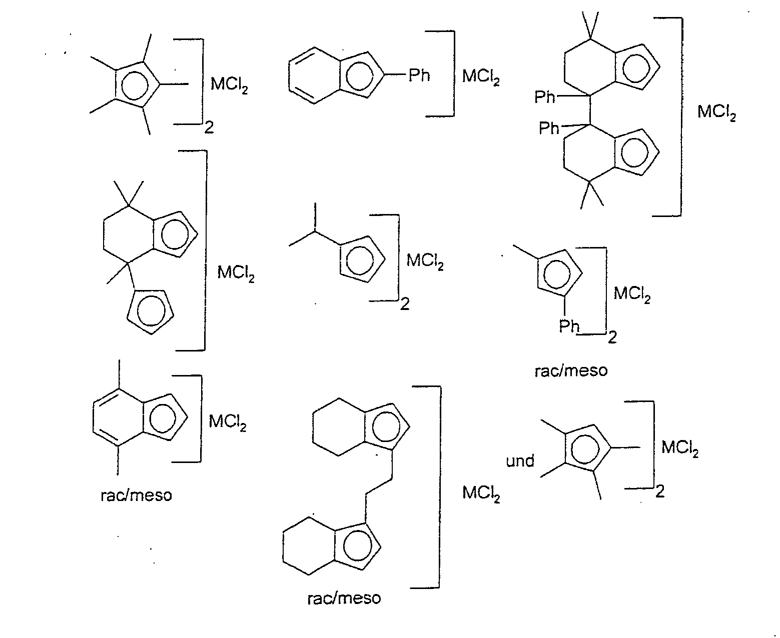 where M is Zr and rac denotes the racemic form of the respective complex and meso denotes the meso form of the respective metal complex.

4. The use according to any of claims 1 to 3, wherein the metallocene complexes are used as emitter molecules in the OLEDs.

5. An OLED comprising at least one zirconocene complex according to any of claims 1 to 4.

6. A light-emitting layer comprising at least one zirconocene complex according to any of claims 1 to 4.

7. A light-emitting layer consisting of at least one zirconocene complex according to any of claims 1 to 4.

8. An OLED comprising the light-emitting layer according to claim 6 or 7.

9. A device selected from the group consisting of stationary VDUs such as VDUs of computers, televisions, VDUs in printers, kitchen appliances and advertising signs, lighting, information signs and mobile VDUs such as VDUs in cellphones, laptops, color televisions and destination displays on buses and trains comprising the OLED according to claim 5 or 8.

## Revendications

1. Utilisation de complexes de zirconocène de formule I 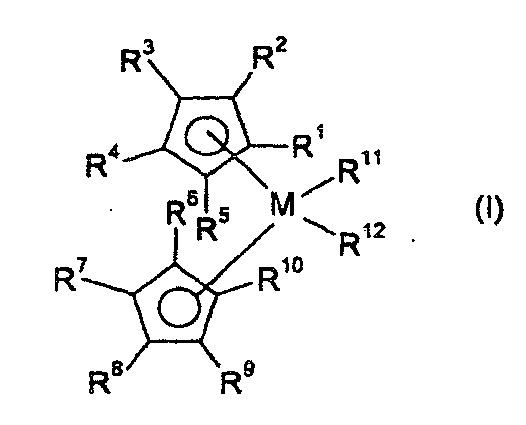 dans laquelle les symboles ont les significations suivantes :
R¹, R², R³, R⁴, R⁵, R⁶, R⁷, R⁸, R⁹, R¹⁰ représentent indépendamment les uns des autres H, alkyle, aryle, alcoxy, hydroxy, aryloxy, halogène, CN, SCN, NO₂, CR¹⁷R¹⁸NR¹⁹R²⁰, CF₃ ; R¹⁷, R¹⁸, R¹⁹, R²⁰ représentant à chaque fois indépendamment les uns des autres H, alkyle ou aryle ; ou
deux radicaux voisins forment un radical cyclique avec les atomes de carbone auxquels ils sont reliés, ledit radical cyclique pouvant être saturé ou insaturé et substitué ou non substitué et pouvant éventuellement contenir un ou plusieurs hétéroatomes ;
et/ou
R⁵ et R¹⁰ forment ensemble un pont qui présente la formule générale - (CR¹³R¹⁴)ₙ-, R¹³ et R¹⁴ représentant à chaque fois indépendamment l'un de l'autre H, alkyle ou aryle, n représentant 1 à 2 et les radicaux R¹³ et R¹⁴ pouvant être identiques ou différents dans les n groupements -(CR¹³R¹⁴)- et l'atome de carbone pouvant être remplacé par Si ou B dans un ou plusieurs des groupements -(CR¹³R¹⁴)- ;
R¹¹, R¹² représentent indépendamment l'un de l'autre alkyle choisi dans le groupe constitué de méthyle, éthyle, i-propyle, n-propyle, i-butyle, n-butyle, t-butyle, sec-butyle, i-pentyle, n-pentyle, sec-pentyle, néo-pentyle, n-hexyle, i-hexyle, sec-hexyle, cyclohexyle et cyclopentyle, aryle, alcoxy, aryloxy, halogène, CN, SCN, CO, alcynyle, alkylthio, arylthio, alkylamido, arylamido, trifluorométhane sulfonate ou un des radicaux forme un pont µ-oxo vers un autre complexe de zirconocène ou d'hafnocène de formule I ;
ou
R¹¹ et R¹² forment ensemble un ligand bidentate ;
M représente Zr,
dans des diodes électroluminescentes.

2. Utilisation selon la revendication 1, **caractérisée en ce que**
R¹ R², R³ , R⁴ , R⁵, R⁶, R⁷, R⁸, R⁹, R¹⁰ représentent indépendamment les uns des autres, H, alkyle, aryle ou halogène
ou
deux radicaux voisins forment un radical orthophényle avec les atomes de carbone auxquels ils sont reliés ;
et/ou
R⁵ et R¹⁰ forment ensemble un pont de formule générale - (CR¹³R¹⁴)ₙ-, R¹³ et R¹⁴ représentant à chaque fois méthyle, n représentant 1 et l'atome C pouvant être remplacé par Si ;
R¹¹, R¹² représentent indépendamment l'un de l'autre, alkyle choisi dans le groupe constitué de méthyle, éthyle, i-propyle, n-propyle, i-butyle, n-butyle, t-butyle, sec-butyle, i-pentyle, n-pentyle, sec-pentyle, néo-pentyle, n-hexyle, i-hexyle, sec-hexyle, cyclohexyle et cyclopentyle, alcoxy, alkylthio, arylthio ou halogène.

3. Utilisation selon la revendication 1 ou 2, **caractérisée en ce que** les complexes de zirconocène sont choisis dans le groupe constitué de 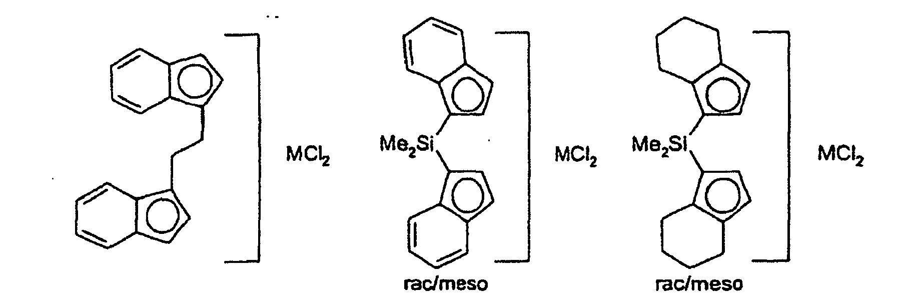 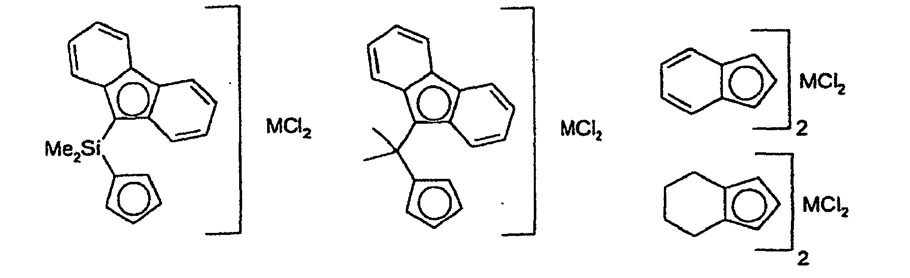 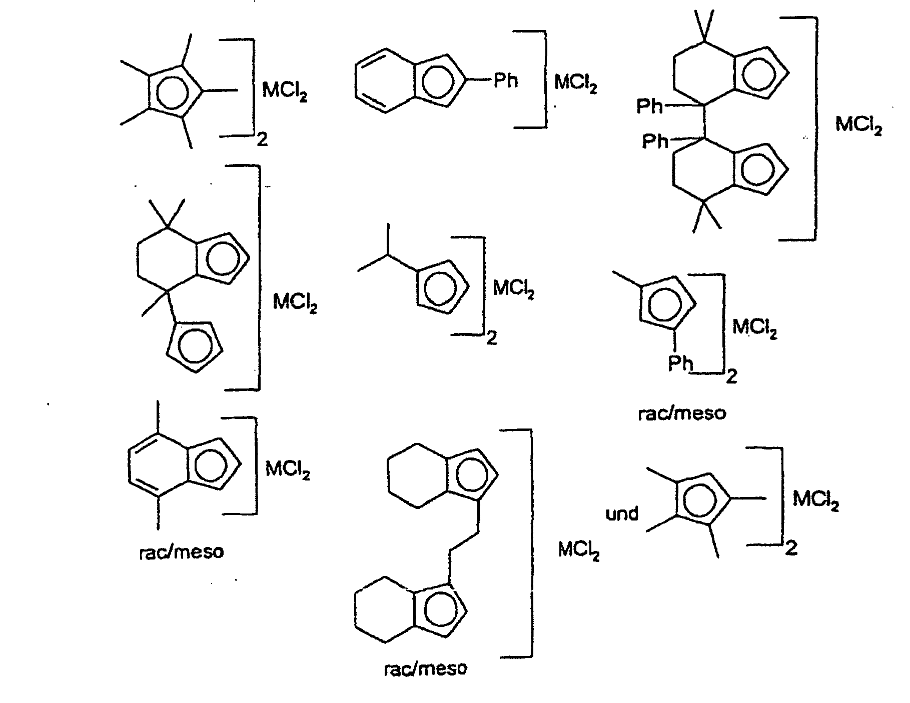 M représentant Zr et rac la forme racémique du complexe correspondant et méso la forme méso du complexe métallique correspondant.

4. Utilisation selon l'une quelconque des revendications 1 à 3, **caractérisée en ce que** les complexes de métallocène sont utilisés en tant que molécules émettrices dans les OLED.

5. OLED contenant au moins un complexe de zirconocène selon l'une quelconque des revendications 1 à 4.

6. Couche électroluminescente contenant au moins un complexe de zirconocène selon l'une quelconque des revendications 1 à 4.

7. Couche électroluminescente constituée d'au moins un complexe de zirconocène selon l'une quelconque des revendications 1 à 4.

8. OLED contenant une couche électroluminescente selon la revendication 6 ou 7.

9. Dispositif choisi dans le groupe constitué des écrans stationnaires tels que les écrans d'ordinateurs, de télévisions, les écrans d'imprimantes, d'appareils de cuisine, ainsi que les panneaux publicitaires, les éclairages, les panneaux indicateurs et des écrans mobiles tels que les écrans de téléphones portables, d'ordinateurs portables, de télévisions en couleurs, ainsi que les indicateurs de destination dans les bus et les trains contenant une OLED selon la revendication 5 ou 8.
